# EUROPEAN PATENT APPLICATION

(11) **EP 4 697 511 A1**
(43) Date of publication of application: **18.02.2026**
(21) Application number: 25185613.4
(22) Date of filing: 26.06.2025
(51) Int. Cl.: H01R 12/57, H01R 12/58, H01R 12/91, H01R 12/52, H01R 12/70, H01R 12/71

(54) **ELECTRONICAL CONNECTOR AND PRESS-FIT TERMINAL THEREOF**

(30) Priority: 14.08.2024 TW 113130474
(71) Applicant: SDI CORPORATION, Chang Hua (TW)
(72) Inventor: Su, Cheng-Ming, Chang Hua (TW); Hong, Shun-Cin, Chang Hua (TW)
(74) Representative: Petraz, Gilberto Luigi

(57) **Abstract**

A press-fit terminal (10) has a fitting portion (20), a base portion (30), and a cushioning structure (40). The fitting portion (20) and the base portion (30) are respectively located at two opposite ends of the press-fit terminal (10) in a fitting direction (D1). The cushioning structure (40) has two connecting portions between the fitting portion (20) and the base portion (30). Each connecting portion has two linear connecting arms (41A, 41B) connected to each other. The two connecting portions surround a polygonal hole (42) formed through two opposite surfaces of the press-fit terminal (10) along the thickness-wise direction (D2). With simple shape design, the cushioning structure (40) can be simply formed by shearing processes, which effectively reduces manufacturing complexity and cost and allows a product of the press-fit terminal (10) to be more controllable.

## Description

### 1. Field of the Invention

The present invention relates to an electronical connecting component, and particularly to a press-fit terminal and an electronical connector having the press-fit terminal.

### 2. Description of Related Art

A press-fit terminal is a common structure applied to connection between electronic components. To avoid structural failure due to overwhelming compression forces when fitting into a press-fit hole, the press-fit terminal normally has a cushioning structure located between a base portion mounted in a shell of an electronic component and a fitting portion fit into the press-fit hole.

A conventional cushioning structure of the press-fit terminal is formed by bending a terminal body of the press-fit terminal in a thickness-wise direction of the terminal body, so as to increase elasticity of the press-fit terminal for cushioning. Another conventional cushioning structure is formed by further bending the terminal body in different directions to balance distribution of forces along the thickness-wise direction, so the press-fit terminal is capable of sustaining a greater force in press-fitting. However, the conventional cushioning structures has the following defects:
1. Despite of the increased elasticity, the press-fit terminal with the conventional cushioning structure bended in the thickness-wise direction tends to be deflected as compression forces are unevenly distributed thereon in the thickness-wise direction.
2. The conventional cushioning structure bended in different directions may ensure more even distribution of forces. Nevertheless, this kind of cushioning structure increases manufacturing complexity, processes, and cost. Also, sizes and deformations of products are more uncontrollable.

To solve the defects of the conventional cushioning structure of the press-fit terminal, the main objective of the present invention is to provide a press-fit terminal and an electronical connector applied therewith that lower manufacturing complexity and allow sizes of products and deformation during press-fitting to be more controllable.

The press-fit terminal provided by the present invention extends along a fitting direction and has a first end, a second end, two surfaces, a fitting portion, a base portion, and a cushioning structure. The first end and the second end are opposite to each other in the fitting direction. The two surfaces are opposite to each other in a thickness-wise direction intersecting the fitting direction. The fitting portion is located at the first end, and the base portion is located at the second end. The cushioning structure has at least two connecting portions arranged at a spaced interval and connected between the fitting portion and the base portion. Each one of the at least two connecting portions has at least two connecting arms connected to each other and each extending linearly. Said connecting arms of two said connecting portions surround a polygonal hole formed through the two surfaces along the thickness-wise direction.

The electronical connector provided by the present invention has a casing and the press-fit terminal described above, and the base portion and the cushioning structure of the press-fit terminal are mounted in the casing.

With the technical features above, the present invention has the following efficacy:
1. Since the polygonal hole of the cushioning structure is formed through the two surfaces, forces tend to be transmitted parallelly to the two surfaces. Thereby, the cushioning structure is less likely to be deflected due to uneven force distribution.
2. The cushioning structure adopts the simple shape design of said connecting arms and the polygonal hole to increase elasticity for cushioning, so the cushioning structure can be formed by only shearing processes. Manufacturing complexity and cost can be effectively reduced. Also, sizes and deformations of the products become more controllable.

Thereby, the press-fit terminal and the electronical connector of the present invention are less deflectable, requires lower complexity and cost in manufacturing, and has controllability over sizes and deformations of the products.

### In the drawings:

Fig. 1 is a perspective view of a press-fit terminal of a first preferred embodiment in accordance with the present invention;
Fig. 2 is a front side view of the press-fit terminal in Fig. 1;
Fig. 3 is a side view of the press-fit terminal in Fig. 1;
Fig. 4 is an operational view of the press-fit terminal in Fig. 1 fit into a press-fit hole;
Fig. 5 is a sectional view of an electronical connector of the first preferred embodiment in accordance with the present invention;
Fig. 6 is a perspective view of the press-fit terminal of a second preferred embodiment in accordance with the present invention;
Fig. 7 is a front side view of the press-fit terminal in Fig. 6;
Fig. 8 is a perspective view of the press-fit terminal of a third preferred embodiment in accordance with the present invention;
Fig. 9 is a front side view of the press-fit terminal in Fig. 8;
Fig. 10 is a front side view of a press-fit terminal of a comparative embodiment;
Fig. 11 is a curve chart of length variations of the press-fit terminals in Figs. 2, 7, 9, and 10 under different compression forces;
Fig. 12 is a curve chart of displacements of endpoints of the press-fit terminals in Figs. 2, 7, 9, and 10 under different compression forces;
Fig. 13 is a curve chart of displacements of first connecting points of the press-fit terminals in Figs. 2, 7, 9, and 10 under different compression forces; and
Fig. 14 is a curve chart of displacements of second connecting points of the press-fit terminals in Figs. 2, 7, 9, and 10 under different compression forces.

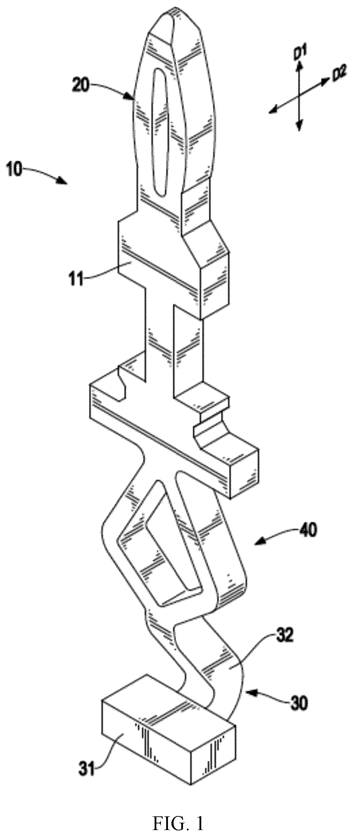

With reference to Figs. 1 to 3, a press-fit terminal 10 of a first preferred embodiment in accordance with the present invention has two surfaces 11 being opposite to each other, a fitting portion 20, a base portion 30, and a cushioning structure 40.

With reference to Figs. 1 to 3, the press-fit terminal 10 extends along a fitting direction D1 and has a first end and a second end being opposite to each other in the fitting direction D1. The first end of the press-fit terminal 10 defines an endpoint E. The fitting portion 20 and the base portion 30 are respectively located at the first end and the second end, and the cushioning structure 40 is located between the fitting portion 20 and the base portion 30. An end of the cushioning structure 40 near the fitting portion 20 defines a first connecting point C1, and the cushioning structure 40 and the base portion 30 are connected at a second connecting point C2.

With reference to Figs. 1 to 3, the two surfaces 11 of the press-fit terminal 10 are opposite to each other in a thickness-wise direction D2 intersecting the fitting direction D1, wherein the two surfaces 11 cover at least from the fitting portion 20 to the cushioning structure 40.

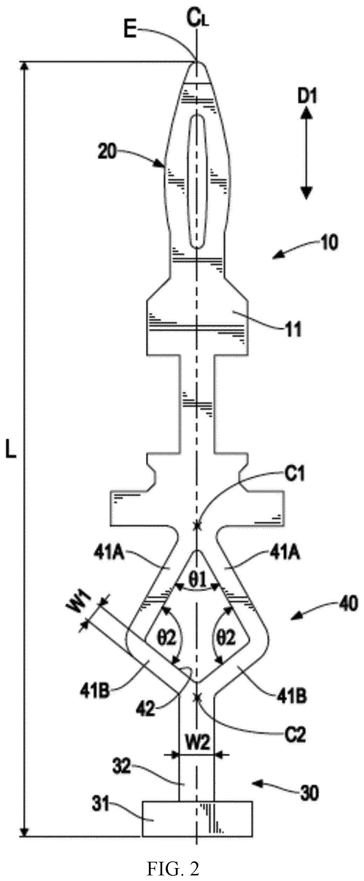

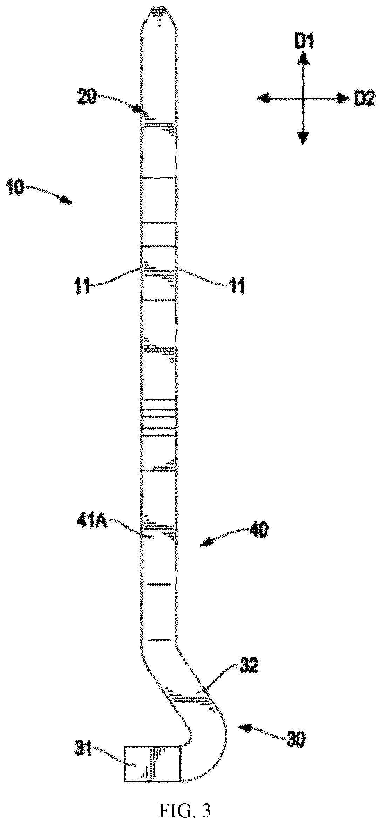

With reference to Figs. 2 and 3, the cushioning structure 40 has two connecting portions arranged at a spaced interval. Each one of the two connecting portions is connected between the base portion 30 and the fitting portion 20 and has two connecting arms that are connected to each other. The two connecting arms are respectively a first connecting arm 41A and a second connecting arm 41B. Each one of the two connecting arms extends linearly. The second connecting arm 41B is connected between the first connecting arm 41A and the base portion 30, and the first connecting arms 41A and the second connecting arms 41B of the two connecting portions jointly surround a polygonal hole 42 formed through the two surfaces 11 of the press-fit terminal 10 along the thickness-wise direction D2.

Specifically, with reference to Fig. 2, the press-fit terminal 10 has a central axis C_{L} defined along the fitting direction D1. The fitting portion 20, the cushioning structure 40, and the base portion 30 are arranged along the central axis C_{L}. The polygonal hole 42 is on the central axis C_{L}, and said connecting arms of each one of the two connecting portions deviate from the central axis C_{L}.

During manufacture of the press-fit terminal 10, a plate metal is processed by punching to form the press-fit terminal 10. First, the plate metal is cut into the shape of the press-fit terminal 10 by shearing, and a top surface and a bottom surface of the plate metal become the two surfaces 11 of the press-fit terminal 10. Also, the connecting arms and the polygonal holes 42 are also cut out during shearing to form the cushioning structure 40 synchronously. Afterwards, further processing and adjustments can be added to the fitting portion 20, the base portion 30, and the cushioning structure 40 upon demands to finish the press-fit terminal 10.

Since the cushioning structure 40 has a simple shape design of said connecting arms surrounding the polygonal hole 42, the cushioning structure 40 can be approximately manufactured by simple shearing processes when manufacturing the press-fit terminal 10. Thus, manufacturing complexity and cost of the press-fit terminal 10 can be effectively reduced.

In other embodiments, each said connecting portion of the cushioning structure 40 may have more than three connecting arms to form said polygonal holes in different shapes, or the cushioning structure 40 may have more than three connecting portions. As long as said connecting arms of adjacent two said connecting portions surround one said polygonal hole 42, the press-fit terminal 10 requires lower manufacturing complexity and cost. Numbers of said connecting arms and said connecting portions of the cushioning structure 40 are not limited to the first preferred embodiment.

Besides, in the first preferred embodiment, the cushioning structure 40 is formed between the two surfaces 11, i.e. the top surface and the bottom surface of the plate metal. After shearing, the cushioning structure 40 is formed already without other adjusting and processing. Further, the fitting portion 20 is also formed between the two surfaces 11. Thereby, transmission of forces from the fitting portion 20 to the cushioning structure 40 can be limited between the two surfaces 11, which improves stability of the press-fit terminal 10 during press-fitting.

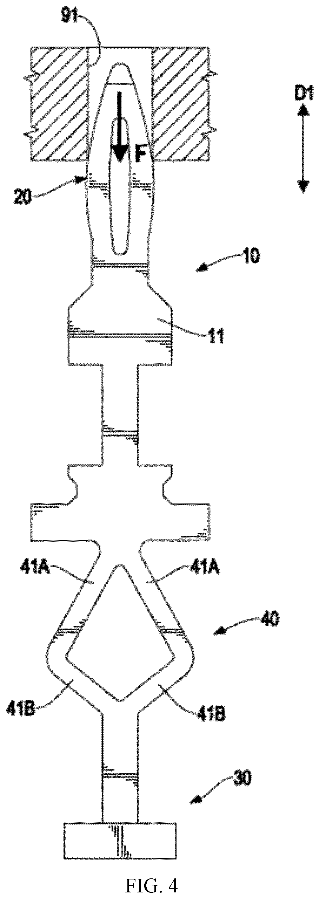

With reference to Fig. 4, the finished press-fit terminal 10 is configured to fit a press-fit hole 91 for structural and electronical connection. The press-fit hole 91 may be disposed on a printed circuit board (PCB), but not limited thereto. First, the press-fit terminal 10 is inserted into the press-fit hole 91 along the fitting direction D1. During press-fitting, the fitting portion 20 of the press-fit terminal 10 is resisted by an edge of the press-fit hole 91, and thus a compression force F acts on the press-fit terminal 10 along the fitting direction D1. At the time, the cushioning structure 40 is elastically deformed to cushion the compression force F.

Specifically, since said connecting arms extend linearly and deviate from the central axis C_{L}, the compression force F is divided into components when being transmitted to said connecting arms. Along with the polygonal hole 42 reducing structural strength and increasing elasticity, the cushioning structure 40 is elastically deformable to act as a cushion, which prevents the press-fit terminal 10 from structural failure due to the compression force F.

Compared to the conventional cushioning structure on a press-fit terminal formed by different bending processes, requiring higher manufacturing complexity and manufacturing cost, and being challenging to be controlled on sizes of products and elastic deformation, the press-fit terminal 10 of the present invention has the following efficacy:
1. Since the polygonal hole 42 of the cushioning structure 40 is formed through the two surfaces 11 along the thickness-wise direction D2, forces tend to be transmitted parallelly to the two surfaces 11. Thereby, the cushioning structure 40 is less likely to be deflected due to uneven force distribution.
2. Since the cushioning structure 40 adopts the shape design of said connecting arms and the polygonal hole 42 to increase elasticity for cushioning, the cushioning structure 40 can be formed by only shearing processes, and the shape of the press-fit terminal 10 can be cut out in the shearing processes as well. Manufacturing complexity, a number of manufacturing processes, and manufacturing cost can be effectively reduced.
3. Since the cushioning structure 40 adopts simple shape design described above and can be formed by the shearing processes, the product of the press-fit terminal 10 has better yield rate and stability. Sizes and deformations of the products become more controllable.

Thence, the present invention provides the press-fit terminal 10 being less deflectable, requiring lower complexity and cost in manufacturing, and having controllability over sizes and deformations of the products.

With reference to Figs. 1 to 3, further, the base portion 30 has a base 31 and a support arm 32, wherein two opposite ends of the support arm 32 are respectively connected to the base 31 and the cushioning structure 40. With reference to Fig. 2, each one of said connecting arms of the cushioning structure 40 has a width, and the support arm 32 has a width larger than that of each said connecting arm. Said connecting arms with smaller widths reduce the structural strength of the cushioning structure 40 to ensure elasticity and the cushioning effect of the cushioning structure 40.

In the first preferred embodiment, a width of each one of said first connecting arm 41A and said second connecting arm 41B equals a first width W1, so sectional areas of said connecting arms sustaining the compression force F are equal. The compression force F is thus distributed more evenly on the cushioning structure 40, and the cushioning structure 40 can be prevented from deflection. Additionally, the width of the support arm 32 equals a second width W2. The first width W1 is smaller than the second width W2 (W1 < W2).

Moreover, the ratio of the first width W1 to the second width W2 is between 0.35 and 0.8, including endpoints value (0.35 ≤ W1/W2 ≤ 0.8). Hence, not only the elasticity and the cushioning effect of the cushioning structure 40 can be ensured, but also said connecting arms 41A, 41B are not too slender to prevent the cushioning structure 40 from over-weakening and fracture. In other embodiments, even if said connecting arms 41A, 41B are of different widths, as long as the ratio of width of each said connecting arm to the width of the support arm 32 is within the above-mentioned range, structural strength of the cushioning structure 40 can meet the requirement for cushioning.

With reference to Fig. 2, preferably, the two connecting portions of the cushioning structure 40 are arranged symmetrically with respect to the central axis C_{L}. Thus, the compression force F is evenly distributed on the two connecting portions of the cushioning structure 40, which allows the cushioning structure 40 to be more stable during press-fitting and further reduces the risk of structural failure. In other embodiments, the cushioning structure 40 may also have four, six, or eight connecting portions. As long as said connecting portions are even in number and are arranged symmetrically with respect to the central axis C_{L}, the compression force F is evenly distributed on said connecting portions respectively on two sides of the central axis C_{L} for greater stability. The number of said connecting portions is not limited to the first preferred embodiment.

In addition, with reference to Fig. 2, said first connecting arms 41A of the two connecting portions form a first angle θ1 therebetween; the first connecting arm 41A and the second connecting arm 41B of each one of the two connecting portions form a second angle θ2 therebetween. A sum of the first angle θ1 and two said second angles θ2 is between 90 and 360 degrees, including endpoints value (90 ≤ θ1 + 2 × θ2 ≤ 360°). With appropriate design of these angles, the cushioning structure 40 can be in a suitable shape for elastic deformation. For example, in the first preferred embodiment, the sum of the first angle θ1 and the two second angles θ2 is greater than 180 degrees (θ1 + 2 × θ2 > 180°), and the cushioning structure 40 is kite-shaped as shown in Fig. 2.

With reference to Figs. 2 and 3, more preferably, the base 31 of the base portion 30, the cushioning structure 40, and the fitting portion 20 are connected along the fitting direction D1, and the support arm 32 of the base portion 30 is bended toward the thickness-wise direction D2. Specifically, after forming shapes of the press-fit terminal 10, the cushioning structure 40, and the fitting portion 20, the second end of the press-fit terminal 10 can be simply bended to form the support arm 32 without over-increasing processes and complexity in manufacturing.

With the bended support arm 32, an extra structure for elastic deformation can be provided between the cushioning structure 40 and the base 31 to improve overall cushioning ability of the press-fit terminal 10. Also, the support arm 32 is further connected to a middle of the base 31, which ensures transmission of the compression force F to be maintained along the fitting direction D1 without deviation. Overall structural stability of the press-fit terminal 10 can thus be guaranteed.

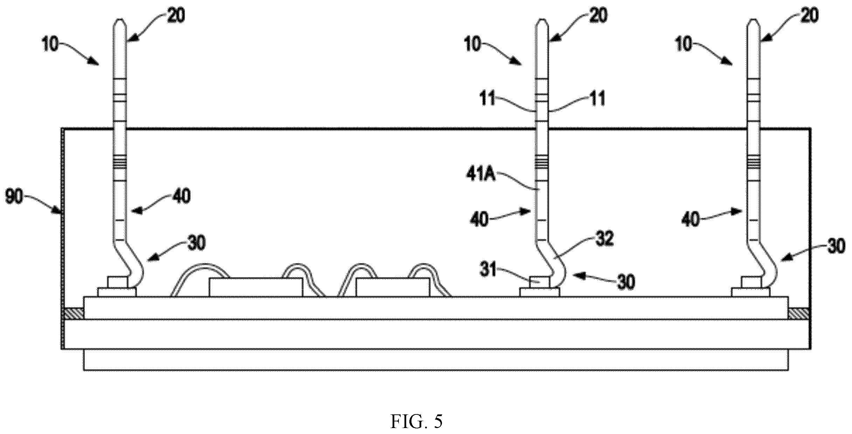

With reference to Fig. 5, the first preferred embodiment in accordance with the present invention further provides an electronical connector having a casing 90 and multiple press-fit terminals 10 described above. The multiple press-fit terminals 10 are disposed on the casing 90 at spaced intervals. The base portion 30 and the cushioning structure 40 of each one of the multiple press-fit terminals 10 is mounted in the casing 90.

Additionally, the electronical connector can be a normal press-fit connector, a wire-to-board connector (WTB connector), a board-to-board connector (BTB connector), or a pin header but is not limited thereto. With the multiple press-fit terminals 10 described above, the electronical connector also requires lower complexity and cost in manufacturing.

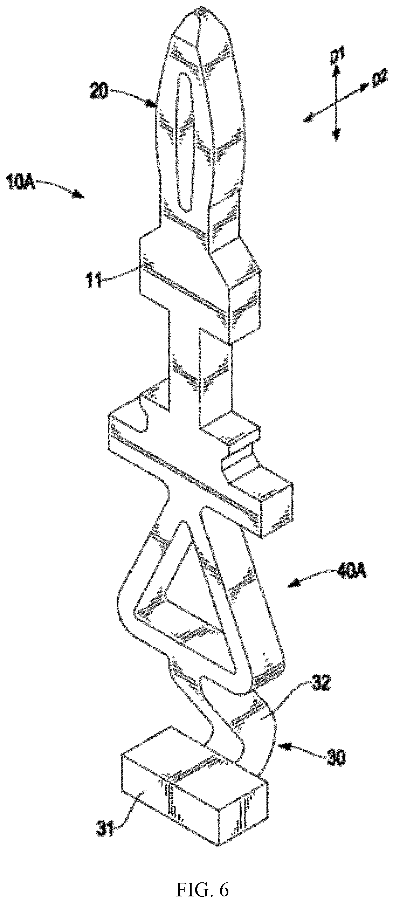

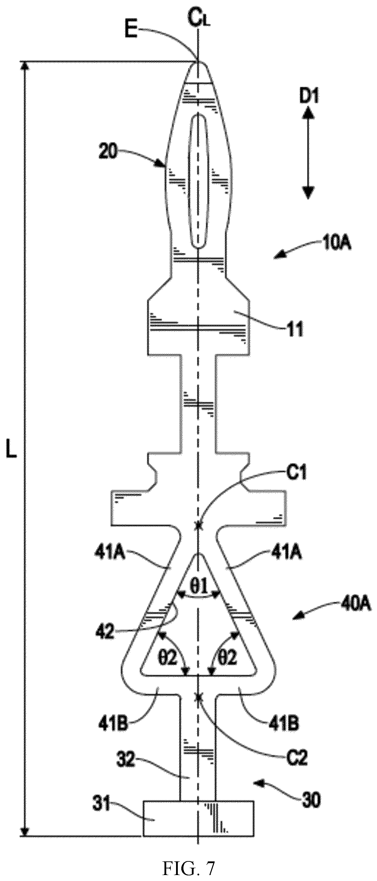

With reference to Figs. 6 and 7, a second preferred embodiment of the present invention provides another press-fit terminal 10A. Differences between the second preferred embodiment and the first embodiment are: the sum of the first angle θ1 and the two second angles θ2 in the second embodiment equals 180 degrees (θ1 + 2 × θ2 = 180°), so the cushioning structure 40A is a triangle. Said second connecting arms 41B of the two connecting portions are connected to each other in a straight line.

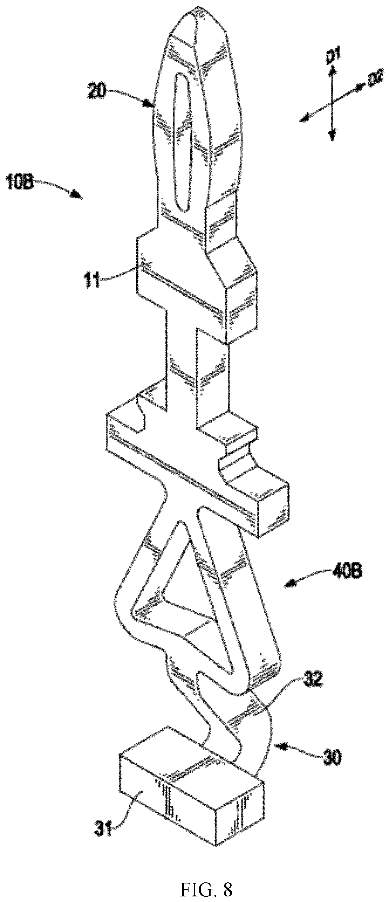

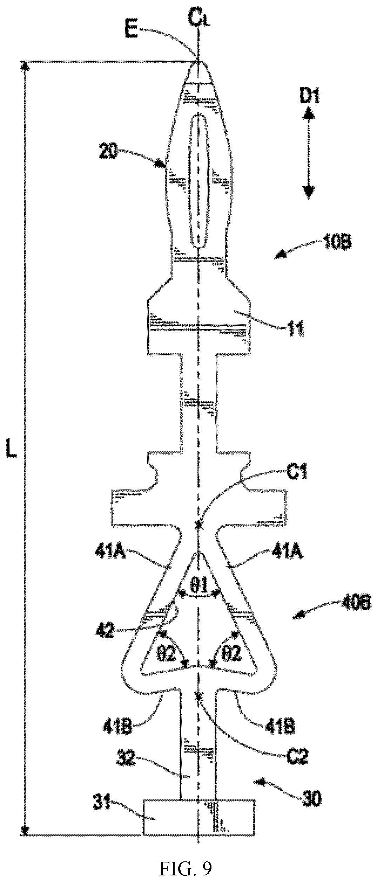

With reference to Figs. 8 and 9, a third preferred embodiment of the present invention provides another press-fit terminal 10B. Differences between the third preferred embodiment and the first embodiment are: the sum of the first angle θ1 and the two second angles θ2 in the third embodiment is lower than 180 degrees (θ1 + 2 × θ2 < 180°), and the cushioning structure 40A is arrow-shaped.

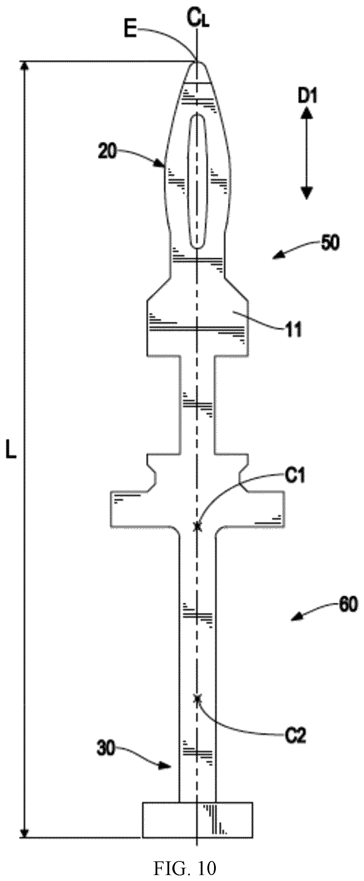

To verify cushioning ability of said cushioning structures 40, 40A, 40B, the press-fit terminals 10, 10A, 10B in the preferred embodiments are compared with a press-fit terminal 50 of a comparative embodiment as shown in Fig. 10. The press-fit terminal 50 of the comparative embodiment only has a straight-line structure 60 extending along the fitting direction D1 between the base portion 30 and the fitting portion 20 instead of the cushioning structure 40, 40A, 40B in the present invention.

Simulations of the compression force F and deformations of the press-fit terminals 10, 10A, 10B, 50 during press-fitting are carried out via computer aided engineering (CAE). With reference to Figs. 2, 7, 9, and 10, the CAE simulations analyze relationships of the compression force F with respect to lengths L and displacements of the endpoints E, the first connecting points C1, and the second connecting point C2 of the above-mentioned press-fit terminals 10, 10A, 10B, 50.

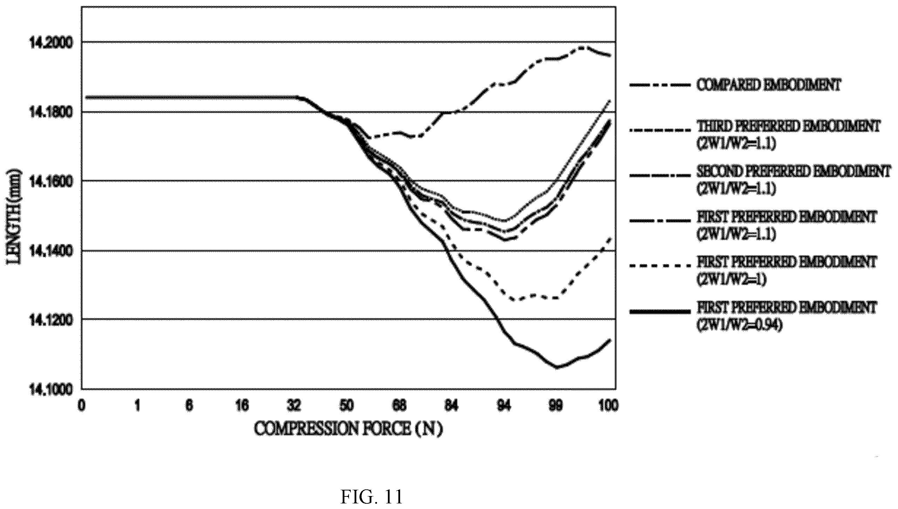

With reference to Figs. 11 to 14, the CAE simulations analyze six different types of press-fit terminals, wherein the length L of each of these press-fit terminals is 14.184mm (millimeter) before the compression force F acts on each press-fit terminal. Three of the six types of these press-fit terminals respectively have said cushioning structures 40, 40A, 40B in the first, the second, and the third preferred embodiments but with a same width ratio. Specifically, in the above three types of press-fit terminals, the first width W1 is 0.35mm, and the second width W2 is 0.64mm. A width ratio is defined as twice the first width W1 to the second width W2 and is 1.1 (2W1/W2 = 1.1). In addition, said second angles θ2 in the first, the second, and the third preferred embodiments are respectively 105 °, 65 °, and 55 °.

Another type of the press-fit terminals is the press-fit terminal 50 of the comparative embodiment in Fig. 10, wherein a width of the straight-line structure 60 is the same as the second width W2 of the above three types of the press-fit terminals 10, 10A, 10B: 0.64mm.

Last two types of the press-fit terminals 10 are from the first preferred embodiment but with different said width ratios. Specifically, in the last two types of the press-fit terminals, said first widths W1 are respectively 0.3 and 0.32mm, and said width ratios are respectively 0.94 and 1 (2W1/W2 = 0.94; 2W1/W2 = 1).

Fig. 11 is a curve chart of length variations of the six different types of the press-fit terminals 10, 10A, 10B, 50 under different compression forces F. Without any cushioning structure 40, 40A, 40B, the length L of the press-fit terminal 50 of the comparative embodiment can only be shortened into a small range, so the press-fit terminal 50 cannot provide enough cushioning effect. Moreover, after the compression force F is over 68N (newton), the fitting portion 20 of the press-fit terminal 50 of the comparative embodiment is deformed due to pressing of the edge of the press-fit hole 91. The press-fit terminal 50 of the comparative embodiment thus extends, and the length L of the press-fit terminal 50 eventually exceeds an original number, which means structural failure of the press-fit terminal 50.

In comparison, with said cushioning structures 40, 40A, 40B being elastically deformable for cushioning, the lengths L of the press-fit terminals 10, 10A, 10B in the three preferred embodiments is shortened more than the length L of the press-fit terminal 50 of the comparative embodiment is. Only after the compression force F exceeds 94N, the cushioning structures 40, 40A, 40B reach limits of elastic deformation, and the lengths L of the press-fit terminals 10, 10A, 10B are lengthened instead due to deformation of the fitting portion 20. Moreover, until the compression force F reaches 100N, lengths L of the press-fit terminals 10, 10A, 10B are still not over the original number. Thereby, stress limits of the press-fit terminals 10, 10A, 10B are increased, and the cushioning structures 40, 40A, 40B surely prevent the press-fit terminals 10, 10A, 10B from structural failure due to the compression force F during press-fitting.

With reference to Fig. 11, regarding shortening of the lengths L, or deformations of the press-fit terminals 10, 10A, 10B, the three preferred embodiments in descending order are the first preferred embodiment (kite-shaped), the second preferred embodiment (triangle), and the third preferred embodiment (arrow-shaped). Thus, the cushioning structure 40 in the first preferred embodiment (kite-shaped) has the greatest shape for the cushioning effect in the three preferred embodiments.

Besides, comparing the press-fit terminals 10 from the first preferred embodiment with different said width ratios to each other, when the width ratio (2W1/W2) is smaller, the length L of the press-fit terminal 10 can be shortened more; that is, the cushioning structure 40 is more elastically deformable. The cushioning structure 40 thus sustains greater compression force F before reaching a limit of elastic deformation, and a stress limit of the press-fit terminal 10 is thus higher. As long as the structural strength of the cushioning structure 40 is sufficient, widths of said connecting arms can be designed according to needs for cushioning ability of the cushioning structure 40.

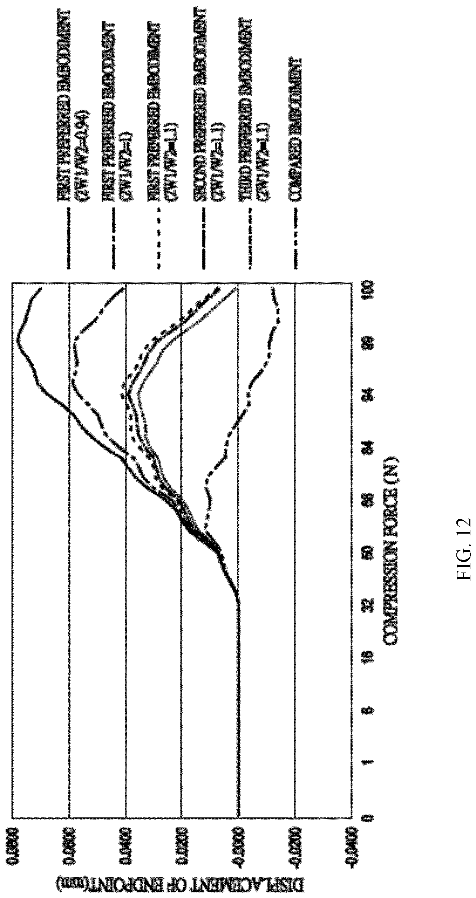

Fig. 12 presents displacements of said endpoints E of the press-fit terminals 10, 10A, 10B, 50 under different compression forces F. The displacement of the endpoint E is defined as a distance of the endpoint E moving toward the base 31 and presents overall deformation of the press-fit terminal as well. Without any cushioning structure 40, 40A, 40B, the displacement of the endpoint E of the press-fit terminal 50 of the comparative embodiment is only between 0.01 and 0.02mm. As described above, the fitting portion 20 is deformed after the compression force F exceeds 68N, and the displacement of the endpoint E thus decreases. The displacement of the endpoint E is even negative (movement away from the base 31) since the length L of the press-fit terminal 50 of the comparative embodiment exceeds the original number.

In comparison, with said cushioning structures 40, 40A, 40B for cushioning, the displacements of said endpoints E of the press-fit terminals 10, 10A, 10B in the three preferred embodiments all reach more than 0.03mm. The press-fit terminals 10, 10A, 10B of the present invention indeed have better elasticity and cushioning ability. Also, in the press-fit terminals 10 from the first preferred embodiments with different said width ratios, when the width ratio (2W1/W2) is smaller, the displacement of the endpoint E and the overall deformation of the press-fit terminal 10 becomes larger. The stress limit of the press-fit terminal 10 thus becomes higher, and the press-fit terminal 10 is less prone to structural failure.

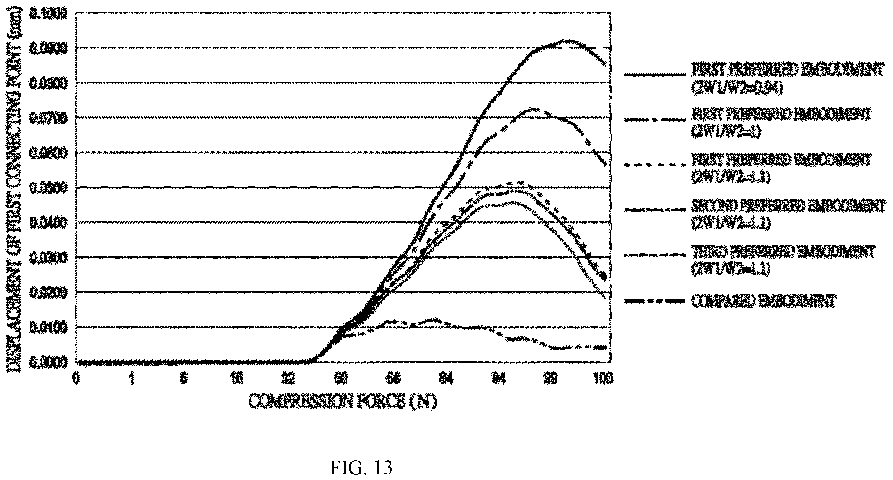

Fig. 13 presents displacements of said first connecting points C1 of the press-fit terminals 10, 10A, 10B, 50. The displacement of the first connecting point C1 is defined as a distance of the first connecting point C1 moving toward the base 31 and presents deformation of the cushioning structure as well. In the three preferred embodiments, the displacements of said first connecting points C1 all reach more than 0.045mm, and in comparison, a displacement of a top end on the straight-line structure 60 of the press-fit terminal 50 of the comparative embodiment is only 0.01mm. Thus, the cushioning structures 40, 40A, 40B increase deformability by more than four times. In the press-fit terminals 10 from the first preferred embodiments with different said width ratios, if the width ratio (2W1/W2) is smaller, a displacement of the first connecting point C1 is larger. The cushioning structures 40 thus have better elasticity for greater cushioning ability.

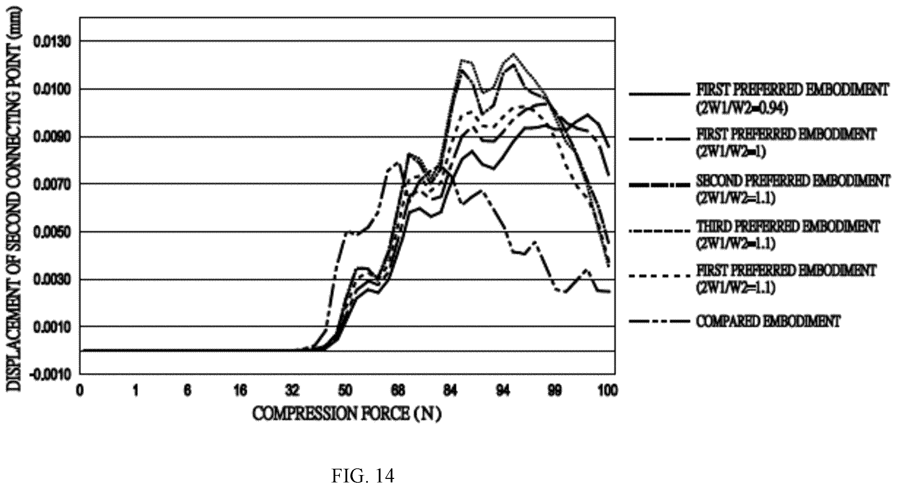

Fig. 14 presents displacements of said second connecting points C2 of the press-fit terminals 10, 10A, 10B, 50. The displacement of the second connecting point C2 is defined as a distance of the second connecting point C2 moving toward the base 31 and presents elastic deformation of the base portion 30 as well. By referring to Figs. 12 to 14, relationship between overall deformations of the press-fit terminals 10, 10A, 10B, deformations of the cushioning structures 40, 40A, 40B and said base portions 30, and deformation of the base portion 30 can be acquired.

With reference to Figs. 12 to 14, the displacement of the second connecting point C2 of each said press-fit terminal of the present invention is no more than 0.01mm, and displacement of the first connecting point C1 of each said press-fit terminal of the present invention is at least 0.045mm. This proves that overall deformations of the press-fit terminals 10, 10A, 10B mainly come from deformations of the cushioning structures 40, 40A, 40B. Also, compared to the press-fit terminal 50 of the comparative embodiment, increase of displacements of the endpoints E in the press-fit terminals 10, 10A, 10B of the present invention mainly come from increase of the displacements of the first connecting points C1 presenting deformations of the cushioning structures 40, 40A, 40B. Thence, the press-fit terminals 10, 10A, 10B of the present invention truly improve elastic deformability and cushioning ability by the cushioning structures 40, 40A, 40B to prevent structural failure.

Even though numerous characteristics and advantages of the present invention have been set forth in the foregoing description, together with details of the structure and features of the invention, the disclosure is illustrative only. Changes may be made in the details, especially in matters of shape, size, and arrangement of parts within the principles of the invention to the full extent indicated by the broad general meaning of the terms in which the appended claims are expressed.

## Claims

1. A press-fit terminal (10) **characterized in** extending along a fitting direction (D1) and comprising:
a first end and a second end being opposite to each other in the fitting direction (D1);
two surfaces (11) being opposite to each other in a thickness-wise direction (D2) intersecting the fitting direction (D1);
a fitting portion (20) located at the first end;
a base portion (30) located at the second end; and
a cushioning structure (40) comprising
at least two connecting portions arranged at a spaced interval and connected between the fitting portion (20) and the base portion (30), and each one of the at least two connecting portions having
at least two connecting arms (41A, 41B) connected to each other and each extending linearly;
wherein said connecting arms (41A, 41B) of two said connecting portions surround a polygonal hole (42) formed through the two surfaces (11) along the thickness-wise direction (D2).

2. The press-fit terminal (10) as claimed in claim 1, wherein
the base portion (30) has a base (31) and a support arm (32);
two ends of the support arm (32) are respectively connected to the base (31) and the cushioning structure (40); and
the support arm (32) has a width (W2) larger than a width (W1) of each one of said connecting arms (41A, 41B) of the cushioning structure (40).

3. The press-fit terminal (10) as claimed in claim 2, wherein a ratio of the width (W1) of each one of said connecting arms (41A, 41B) of the cushioning structure (40) to the width (W2) of the support arm (32) is between 0.35 and 0.8, including endpoint values.

4. The press-fit terminal (10) as claimed in claim 2, wherein all said connecting arms (41A, 41B) of the cushioning structure (40) are of the same width.

5. The press-fit terminal (10) as claimed in any one of claims 1 to 4, wherein the press-fit terminal (10) comprises a central axis (C_{L}) extending along the fitting direction (D1);
the at least two connecting portions of the cushioning structure (40) are even in number; and
the at least two connecting portions are arranged symmetrically with respect to the central axis (C_{L}) of the press-fit terminal (10).

6. The press-fit terminal (10) as claimed in claim 5, wherein
the cushioning structure (40) has two said connecting portions;
each one of the two connecting portions has two said connecting arms (41A, 41B) respectively being
a first connecting arm (41A); and
a second connecting arm (41B) connected between the first connecting arm (41A) and the base portion (30);
said first connecting arms (41A, 41B) of the two connecting portions form a first angle (θ1) therebetween;
the first connecting arm (41A) and the second connecting arm (41B) of each one of the two connecting portions form a second angle (θ2) therebetween; and
a sum of the first angle (θ1) and two said second angles (θ2) is between 90 and 360 degrees, including endpoint values.

7. The press-fit terminal (10) as claimed in claim 6, wherein the sum of the first angle (θ1) and the two second angles (θ2) is greater than 180 degrees.

8. The press-fit terminal (10) as claimed in claim 6, wherein the sum of the first angle (θ1) and the two second angles (θ2) equals 180 degrees.

9. The press-fit terminal (10) as claimed in claim 1, wherein
the base portion (30) has a base (31) and a support arm (32);
two ends of the support arm (32) are respectively connected to the base (31) and the cushioning structure (40);
the base (31), the cushioning structure (40), and the fitting portion (20) are connected along the fitting direction (D1); and
the support arm (32) is bended toward the thickness-wise direction (D2).

10. An electronical connector **characterized in** comprising:
a casing (90); and
the press-fit terminal (10) as claimed in any one of claims 1 to 9;
wherein the base portion (30) and the cushioning structure (40) of the press-fit terminal (10) are mounted in the casing (90).
